Europäisches Patentamt

**European Patent Office**

**Office européen des brevets**

(19)

(11) Numéro de publication: **0 231 688 B1**

(12) **FASCICULE DE BREVET EUROPEEN**

(45) Date de publication du fascicule du brevet:
**03.10.90**

(51) Int. Cl.⁵: **H01L 21/82**, H01L 29/60, H01L 29/78

(21) Numéro de dépôt: **86402751.1**

(22) Date de dépôt: **10.12.86**

(54) Procédé de réalisation d'un dispositif à transfert de charges, et dispositif obtenu par ce procédé.

(30) Priorité: **10.12.85 FR 8518257**

(43) Date de publication de la demande:
**12.08.87 Bulletin 87/33**

(45) Mention de la délivrance du brevet:
**03.10.90 Bulletin 90/40**

(84) Etats contractants désignés:
**DE GB NL**

(56) Documents cités:
**FR-A- 2 227 646**
**NL-A- 7 902 878**

(73) Titulaire: **THOMSON-CSF, 51, Esplanade du Général de Gaulle, F-92800 Puteaux(FR)**

(72) Inventeur: **Thenoz, Yves, THOMSON-CSF SCPI 19, avenue de Messine, F-75008 Paris(FR)**

(74) Mandataire: **Mayeux, Michèle et al, THOMSON-CSF SCPI, F-92045 PARIS LA DEFENSE CEDEX 67(FR)**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

ACTORUM AG

## Description

L'invention concerne un procédé de réalisation d'un dispositif à transfert de charges applicable plus particulièrement à la réalisation d'un dispositif à transfert de charges à deux phases à canal enterré et offrant l'avantage de ne pas présenter de barrière de potentiels parasites. Elle concerne également un dispositif obtenu par ce procédé.

Les dispositifs à transfert de charges à deux phases à canal enterré sont constitués par une alternance de grilles de stockage et de grilles de transfert.

Les grilles de stockage sont caractérisés par un dopage de canal plus fort que celui des grilles de transfert.

Les procédés connus de fabrication des dispositifs à transfert de charges à deux phases consistent à réaliser par implantation le canal des grilles de stockage en premier, puis à réduire le dopage du canal sous les grilles de transfert par implantation d'ions de type opposé à celui du canal, autoalignées par rapport aux grilles de stockage.

Ce procédé conduit à une diffusion latérale des impuretés de compensation de type opposé à celui du canal sous la grille de stockage, diffusion qui n'est pas voulue mais qui est inévitable.

Or la théorie montre que, à configuration donnée, les charges stockées dans un canal enterré se rapprochent de l'interface silicium-silice quand le dopage du canal est réduit. De même, le potentiel du canal, à vide de porteurs, diminue, ce qui est le cas le long des grilles de stockage à cause de l'implantation de compensation.

Les deux phénomènes limitent les performances de ces dispositifs parce que les charges doivent rester en volume et ne jamais atteindre la surface (l'interface silicium-silice) et parce que le potentiel du canal à vide de porteurs pendant la période de transfert doit être monotone croissant dans le sens du transfert et ne pas présenter de barrière de potentiel qui limite la qualité du transfert.

Ces limitations sont d'autant plus importantes que les épaisseurs des diélectriques de grilles et la profondeur de jonction du canal sont faibles comme dans le cas des technologies CCD dites VLSI.

Le procédé de l'invention permet d'obtenir un dispositif à transfert de charges ne présentant pas ces inconvénients.

L'invention concerne donc un procédé de réalisation d'un dispositif à transfert de charges caractérisé en ce qu'il comporte les étapes successives suivantes:

- une première étape de réalisation, sur une face d'un substrat en matériau semiconducteur de type déterminé, d'une couche d'un même matériau mais de type opposé de façon à obtenir un canal;
- une deuxième étape de réalisation d'une couche d'un matériau diélectrique sur la couche précédente;
- une troisième étape de réalisation sur la couche de matériau diélectrique, d'électrodes inférieures séparées par des espaces;
- une quatrième étape de surdopage de la couche dans les espaces non recouverts par les électrodes inférieures à l'aide d'ions de même type de conductivité que celui de la couche de façon à obtenir des zones surdopées du canal autoalignées par rapport aux électrodes inférieures, ce surdopage de la couche se faisant selon une épaisseur limitée de la couche;
- une cinquième étape de réalisation d'électrodes supérieures recouvrant au moins chacune un desdits espaces.

L'invention concerne également un dispositif à transfert de charges selon la revendication 5 et comportant, disposées sur un substrat en semiconducteurs, des électrodes inférieures séparées par des espaces ainsi que des électrodes supérieures recouvrant chacune au moins un espace, ledit dispositif étant tel que le substrat comporte sous lesdites électrodes un canal de transfert de charges en volume dopé à l'aide d'impuretés de type différent à celui du substrat, ledit canal étant surdopé dans les zones correspondant aux espaces et selon une profondeur limitée du canal.

Les différents objets et caractéristiques de l'invention apparaîtront plus clairement dans la description qui va suivre faite en se reportant aux figures annexées qui représentent :

- la figure 1, une vue d'un dispositif à transfert de charges selon l'art connu ;
- la figure 2, une vue d'un exemple de dispositif à transfert de charges selon l'invention.

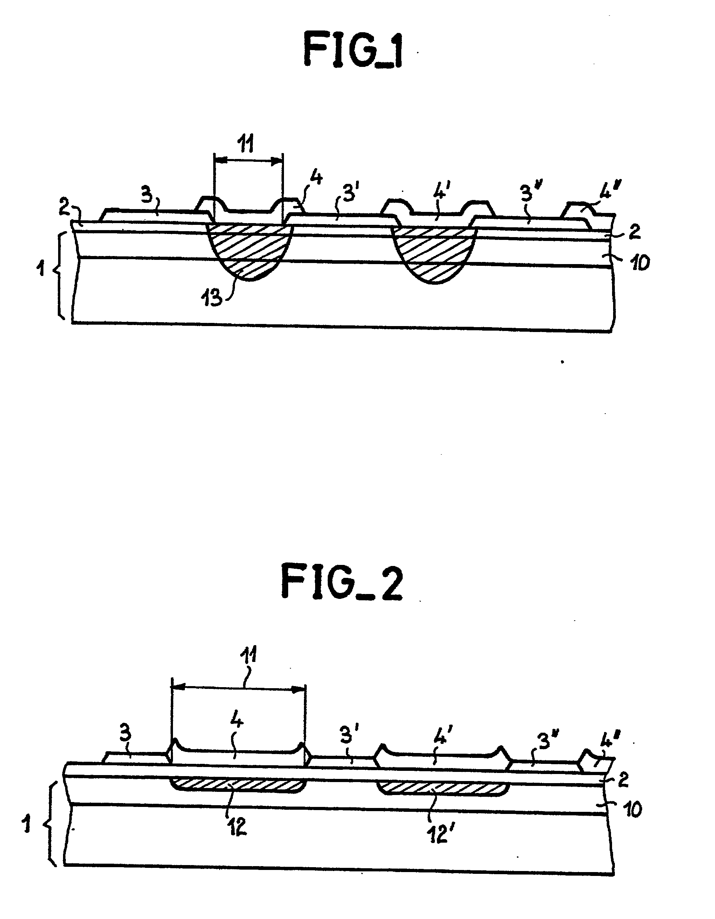

En se reportant à la figure 1, on va tout d'abord décrire un dispositif à transfert de charges connu dans la technique.

Les dispositifs à transfert de charges à deux phases nécessitent deux niveaux d'électrodes :
- des électrodes 3, 3', 3" que nous appellerons électrodes inférieures dans la suite de la description ;
- des électrodes 4, 4', 4" que nous appellerons électrodes supérieures dans la suite de la description car il arrive qu'elles recouvrent partiellement les électrodes inférieures dans certains cas de réalisation tels que celui représenté en figure 1.

Ces électrodes sont déposées sur un substrat 1 en matériau semiconducteur tel que du silicium. La couche supérieure du substrat 1 a été dopée à l'aide d'impuretés. Ces impuretés sont de type N en supposant que le substrat est de type P. On a ainsi un canal 10 de transfert de charges.

Si on considère que les électrodes inférieures 3, 3', 3" sont des électrodes de stockage et les électrodes supérieures 4, 4', 4" sont des électrodes de transfert pour le dispositif à transfert de charges, il convient dans un système à deux phases de fonctionnement d'imposer un sens de transfert des charges.

Dans le cas du canal de type N, le sens de transfert est obtenu par une implantation de type P, d'impuretés de bore par exemple, autoalignée par rapport aux bords des électrodes inférieures.

· Ces impuretés ont un coefficient de diffusion nettement plus grand que celui des impuretés utilisées pour doper le canal à jonction de profondeur réduite (As, Sb), ce qui crée deux inconvénients :
- le surdopage du substrat 1 par l'implant de bore avec ses effets indésirables sur les lignes de po-

tentiels, la réduction du $X_j$ résultant du canal et la difficulté de reproduction exactement identique de la dose de compensation contenue dans le canal ;
- la diffusion latérale du bore sous les électrodes inférieures (électrodes de stockage) avec formation de barrière de potentiels parasites d'autant plus importante que les dimensions en vertical sont réduites (épaisseur d'oxyde et profondeur de canal).

Le procédé de l'invention permet d'obtenir un dispositif à transfert de charges évitant ces inconvénients.

Selon une première étape de ce procédé on réalise, à la surface d'un substrat 1 en matériau semiconducteur tel que du silicium d'un type déterminé, une couche 10 d'un type opposé. Cela peut se faire par dopage par implantation. Par exemple, dans le cas d'un substrat de type P, on réalise un dopage par implantation d'impuretés de type N. On obtient ainsi à la surface du substrat un canal (10) qui servira de canal de transfert des charges.

Selon une deuxième étape on réalise une couche (2) en matériau diélectrique tel qu'un oxyde.

Au cours d'une troisième étape, on réalise sur la couche d'oxyde 2, des électrodes inférieures 3, 3',3" séparées les unes des autres par des espaces tel que 11. La réalisation de ces électrodes est connue dans la technique. Elle se fait par gravure dans une couche d'un matériau, tel que du silicium polycristallin, déposée sur la couche d'oxyde 2.

Au cours d'une quatrième étape, on réalise un dopage du substrat 1 à l'aide d'impuretés de type N, comme cela a été fait précédemment au cours de la première étape. Cependant, au cours de cette troisième étape, les électrodes inférieures 3, 3', 3" réalisées précédemment remplissent le rôle de masques et le dopage se fait de façon autoalignée avec les bords des électrodes inférieures 3, 3', 3".

Au cours d'une cinquième étape, on réalise les électrodes supérieures 4, 4', 4" de telle façon qu'elles recouvrent en totalité les espaces 11 séparant les électrodes inférieures 3, 3',3".

On obtient ainsi un dispositif à transfert de charges tel que représenté en figure 2, avec à la face supérieure du substrat 1, un canal de transfert 10, revêtu d'une couche d'oxyde 2. la couche d'oxyde 2, on trouve des électrodes inférieures 3, 3', 3" séparées par des espaces 11. Les espaces 11 sont recouverts par des électrodes supérieures 4, 4', 4". Sous les espaces 11, le canal 10 a été surdopé dans une partie 12 de son épaisseur.

Dans un tel dispositif à transfert de chages, le stockage des charges se fait sous les électrodes supérieures 4, 4', 4" dans la zone surdopée et le transfert des charges se fait sous les électrodes inférieures 3, 3', 3".

Le surdopage 12 réalisé crée une dissymétrie de doses entre le stockage et le transfert.

En réalisant le surdopage à l'aide des mêmes impuretés que celles du canal, le surdopage 12 reste entièrement dans le canal 10 et la diffusion latérale des impuretés sous les électrodes inférieures 3, 3', 3" est d'autant plus réduite que la jonction du canal est faiblement enterrée.

Le procédé de l'invention permet donc d'éviter des variations de dopage substrat entre les deux niveaux de grilles et des modifications de profondeur de fonction de canal, il permet également un meilleur contrôle de la dose de dissymétrie qui se trouve entièrement contenues dans le canal.

Le principal avantage de ce procédé se révèle en VLSI où les profondeurs de jonction de canal doivent être très faibles. Dans ce cas, l'absence d'impuretés de bore diffusées latéralement sous les électrodes inférieures évite la présence de barrière de potentiel aux extrémités des électrodes inférieures qui peuvent limiter sensiblement la qualité du transfert.

Le procédé de l'invention permet donc de supprimer ces effets parasites en implantant en premier le canal des grilles de transfert et en surdopant le canal des grilles de stockage par implantation d'ions de même type que celui du canal, autoalignée par rapport à la grille de transfert.

Dans le cas du substrat de type P et du canal de type N, ce procédé permet de réduire les amplitudes des diffusions latérales parce que le surdopage dans le procédé de l'invention se fait avec des impuretés qui ont des coefficients de diffusion beaucoup plus faibles (As, Sb) que ceux des impuretés utilisées dans l'ancien procédé pour compenser le canal (Bore).

La différence fondamentale entre les deux procédés réside dans le fait que les effets indésirés des diffusions latérales sont néfastes dans l'ancien procédé (rapprochement des charges de l'interface) et sont sans inconvénient majeur pour le nouveau procédé (éloignement des charges de l'interface le long des grilles de transfert).

Le procédé de l'invention peut être utilisé pour la réalisation de tout dispositif à transfert de charges à deux phases. Son utilisation est d'autant plus avantageuse que le canal enterré est peu profond ce qui est le cas notamment en intégration à grande échelle (VLSI = very large scale integration, en terminologie anglo-saxonne).

Ce procédé peut trouver une application très intéressante dans le cas de dispositifs à transfert de charges à deux phases péristaltiques à deux implantations de canal : une implantation à forte dose et faible jonction et une implantation à faible dose et à jonction profonde. Cette deuxième implantation a pour but d'augmenter les champs latéraux pour améliorer le transfert à haute fréquence. Le procédé décrit permet de réaliser une dissymétrie sans affecter l'effet "péristaltique".

A titre d'exemple, le procédé de l'invention sera réalisé avec un substrat de concentration inférieure à $10^{16}$ atomes/cm$^3$.

Le canal obtenu pourra avoir une profondeur inférieure à 0,5 micromètres et une concentration comprise entre $10^{16}$ et $10^{18}$ atomes/cm$^3$.

L'épaisseur d'oxyde sera comprise entre 30 nm (300 Å) et 100 nm (1000 Å).

Enfin, la différence de dopage entre les zones du canal 10 situées sous les électrodes inférieures 3, 3', 3" et les zones surdopées 12, 12' situées sous les électrodes supérieures 4, 4', 4" sera de l'ordre de quelques $10^{16}$ atomes/cm$^3$.

Ces valeurs numériques n'ont été données qu'à titre d'exemple mais d'autres exemples de réalisation peuvent être envisagés sans sortir pour autant du cadre de l'invention défini par les revendications.

## Revendications

1. Procédé de réalisation d'un dispositif à transfert de charges comportant les étapes successives suivantes:

– une première étape de réalisation, sur une face d'un substrat (1) en matériau semiconducteur de type déterminé, d'une couche (10) d'un même matériau mais de type opposé de façon à obtenir un canal (10);

– une deuxième étape de réalisation d'une couche d'un matériau diélectrique (2) sur la couche (10) précédente;

– une troisième étape de réalisation sur la couche de matériau diélectrique (2), d'électrodes inférieures (3, 3', 3") séparées par des espaces (11);

– une quatrième étape de surdopage de la couche (10) dans les espaces (11) non recouverts par les électrodes inférieures (3, 3', 3") à l'aide d'ions de même type de conductivité que celui de la couche (10) de façon à obtenir des zones (12, 12') surdopées du canal (10) autoalignées par rapport aux électrodes inférieures (3, 3', 3"), ce surdopage de la couche (10) se faisant selon une épaisseur limitée de la couche (10);

–une cinquième étape de réalisation d'électrodes supérieures (4, 4', 4") recouvrant au moins chacune un desdits espaces (11).

2. Procédé de réalisation d'un dispositif à transfert de charges selon la revendication 1, caractérisé en ce que la première étape de réalisation d'une couche de type opposé à celui du substrat et la quatrième étape de surdopage se font par dopage par implantation.

3. Procédé de réalisation d'un dispositif à transfert de charges selon la revendication 2, caractérisé en ce que le substrat (1) est de type P, le dopage de la première étape et celui de la quatrième étape sont réalisées à l'aide d'impuretés de type N.

4. Procédé de réalisation d'un dispositif à transfert de charges selon la revendication 2, caractérisé en ce que le substrat (1) est de type N, le dopage de la première étape et celui de la quatrième étape sont réalisées à l'aide d'impuretés de type P.

5. Dispositif à transfert de charges réalisé par le procédé selon l'une quelconque des revendications précédentes, comportant, disposées sur un substrat (1) en semiconducteurs, des électrodes inférieures (3, 3', 3") séparées par des espaces (11) ainsi que des électrodes supérieures (4, 4', 4") recouvrant chacune au moins un espace (11), caractérisé en ce que le substrat (1) comporte sous lesdites électrodes un canal (10) de transfert de charges en volume dopé à l'aide d'impuretés de type différent de celui du substrat (1), ledit canal étant surdopé dans les zones correspondant aux espaces (11) et selon une profondeur limitée du canal (10).

## Claims

1 A method of fabricating a charge transfer device comprising the following successive stages:

- a first stage for the production, on a surface of a substrate (1) of a given type of semiconductor material, of a layer (10) of the same material but of the opposite type in order to produce a channel (10),

- a second stage for the production of a layer of dielectric material (2), on the preceding layer (10),

- a third stage for the production, on the layer of dielectric material (2), of lower electrodes (3, 3' and 3") separated by spaces (11),

- a fourth stage of overdoping of the layer (10) in the spaces (11) which are not covered by the lower electrodes (3, 3' and 3") with the aid of ions of the same type of conductivity as that of the layer (10) in such a manner as to produce overdoped zones (12 and 12') of the channel (10) which are selfaligned with respect to the lower electrodes (3, 3' and 3"), said overdoping of the layer (10) being performed in line with a limited thickness of the layer (10), and

- a fifth stage of producing upper electrodes (4, 4' and 4") at least each of them covering one of the said spaces (11).

2 The method of producing a charge transfer device as claimed in claim 1, characterized in that the first stage of producing a layer of the type opposite to that of the substrate and the fourth stage of overdoping are performed by implantation doping.

3 The method of producing a charge transfer device as claimed in claim 2, characterized in that the substrate (1) is of the P type, the doping operation in the first stage and that of the fourth stage being performed with the aid of N type impurities.

4 The method of producing a charge transfer device as claimed in claim 2, characterized in that the substrate (1) is of the N type, the doping operation in the first stage and the doping operation in the fourth stage being performed with the aid of P type impurities.

5 A charge transfer device as produced by the method as claimed in any one of the preceding claims, comprising, placed on a substrate (1) of semiconductors, lower electrodes (3, 3' and 3"), separated by spaces (11) and upper electrodes (4, 4' and 4") each covering at least one space (11), characterized in that under the electrodes the substrate (1) comprises a volume charge transfer channel (10) doped with aid of impurities of a type different to that of the substrate (1), the said channel being overdoped in zones corresponding to the spaces (11) and in line with a limited depth of the channel (10).

## Patentansprüche

· 1. Verfahren zur Herstellung einer mit Ladungsüberführung arbeitenden Einrichtung, mit den folgenden, aufeinanderfolgenden Schritten:

- einen ersten Schritt zur Herstellung einer Schicht (10) auf einer Seite eines Substrats (1), das aus einem Halbleitermaterial von bestimmter Art besteht, wobei die Schicht (10) aus dem gleichen Material, jedoch von entgegengesetzter Art, besteht, um so einen Kanal (10) zu erhalten;
- einen zweiten Schritt zur Herstellung einer Schicht aus dielektrischem Material (2) auf der vorangehenden Schicht (10);
- einen dritten Schritt zur Herstellung von unteren Elektroden (3, 3', 3 ") auf der Schicht aus dielektrischem Material (2), wobei die Elektroden durch Zwischenräume (11) getrennt sind;
- einen vierten Schritt der Überdotierung der Schicht (10) in den nicht von den unteren Elektroden (3, 3' 3") abgedeckten Zwischenräumen (11) mit Hilfe von Ionen des gleichen Leitungstyps wie derjenige der Schicht (10), um so überdotierte Zonen (12, 12') des Kanals (10) zu erhalten, die sich in bezug auf die unteren Elektroden (3, 3', 3") selbst ausrichten, wobei diese Überdotierung der Schicht (10) entsprechend der begrenzten Dicke der Schicht (10) ausgeführt wird;
- einen fünften Schritt zur Herstellung von oberen Elektroden (4, 4', 4"), die wenigstens jeden der Zwischenräume (11) abdecken.

2. Verfahren zur Herstellung einer Einrichtung zum Ladungstransport gemäß Anspruch 1, dadurch gekennzeichnet, daß der erste Schritt zur Herstellung einer Schicht einer Art, die derjenigen des Substrats entgegengesetzt ist, und der vierte Schritt der Überdotierung mittels Implantationsdotierung ausgeführt werden.

3. Verfahren zur Herstellung einer Vorrichtung zum Ladungstransport gemäß Anspruch 2, dadurch gekennzeichnet, daß das Substrat (1) vom P-Typ ist und daß die Dotierungen des ersten Schrittes und des vierten Schrittes mit Hilfe von N-Typ-Störstellen verwirklicht werden.

4. Verfahren zur Herstellung einer Einrichtung zum Ladungstransport gemäß Anspruch 2, dadurch gekennzeichnet, daß das Substrat (1) vom N-Typ ist und daß die Dotierungen des ersten Schrittes und des vierten Schrittes mit Hilfe von P-Typ-Störstellen verwirklicht werden.

5. Einrichtung zum Ladungstransport, die mit dem Verfahren gemäß einem der vorangehenden Ansprüche hergestellt wird, mit auf einem Substrat (1) eines Halbleiters angeordneten unteren Elektroden (3, 3', 3"), die durch Zwischenräume (11) getrennt sind, und mit oberen Elektroden (4, 4', 4"), die jeweils wenigstens einen der Zwischenräume (11) bedecken, dadurch gekennzeichnet, daß das Substrat (1) unterhalb der Elektroden einen Kanal (10) zum Ladungstransport aufweist, dessen Volumen mit Hilfe von Störstellen dotiert ist, deren Art von derjenigen des Substrates (1) verschieden ist, wobei der Kanal in den den Zwischenräumen (11) entsprechenden Zonen und entsprechend der begrenzten Tiefe des Kanals (10) überdotiert ist.

# FIG_1

# FIG_2